# DEMANDE DE BREVET EUROPEEN

(11) **EP 0 572 319 A1**
(43) Date de publication de la demande: **01.12.1993**
(21) Numéro de dépôt: 93401346.7
(22) Date de dépôt: 26.05.1993
(51) Int. Cl.: G01R 21/08, G01R 15/00

(54) **Dispositif de mesure électrotechnique polyvalent**

(30) Priorité: 26.05.1992 FR 9206443
(71) Demandeur: Odet, Georges, F-69970 Chaponnay (FR)
(72) Inventeur: Odet, Georges, F-69970 Chaponnay (FR)
(74) Mandataire: Derambure, Christian

(57) **Abrégé**

L'invention concerne un dispositif de mesure électrotechnique polyvalent pour la mesure des caractéristiques d'une machine électrotechnique d'un type quelconque, comprenant des moyens (2, 3) de connexion électrique en parallèle et/ou en série du dispositif à un circuit électrique associé à la machine électrotechnique caractérisé en ce que les moyens (2, 3) de connexion électrique comprennent au moins une paire de bornes (3) de connexion en série pour la détection d'une intensité reliées l'une à l'autre par un conducteur primaire (5) couplé à un capteur d'intensité par effet Hall (7) délivrant un signal représentatif de l'intensité, et au moins une paire de bornes (2) de connexion parallèle pour la détection d'une tension reliées l'une à l'autre par un conducteur primaire (4) comprenant une résistance (8) en série, et couplé avec un capteur d'intensité par effet Hall (6) délivrant un signal représentatif de la tension.

## Description

L'invention concerne un dispositif de mesure électrotechnique polyvalent pour la mesure des caractéristiques d'une machine électrotechnique telle qu'une machine à courant continu ; une machine asynchrone, synchrone, monophasée ou polyphasé ; un transformateur monophasé ou polyphasé ; un variateur de vitesse ...

On connaît déjà de nombreux modes de réalisation de dispositifs de mesure électrotechnique pour la mesure d'une caractéristique électrique d'un circuit (tension, intensité, puissance, fréquence ...) ainsi que des dispositifs de mesure d'une pluralité de caractéristiques électriques d'une machine électrotechnique ou d'un circuit d'un type bien particulier et prédéterminé. Certains de ces dispositifs de mesure permettent la liaison avec un dispositif de traitement de l'information numérique de façon à bénéficier des possibilités de calcul et de traitement sur les valeurs mesurées.

Néanmoins, la réalisation d'un dispositif de mesure électrotechnique polyvalent permettant la mesure d'une pluralité de caractéristiques électrotechniques - notamment de l'intégralité des caractéristiques principales - d'une machine électrotechnique d'un type quelconque, pose le problème de la sécurité de l'utilisateur. En effet, les branchements à réaliser sur le circuit entre la source de courant et la charge varient considérablement selon le type du circuit (monophasé, polyphasé, équilibré ou non équilibré ...), et selon le type de charge, c'est-à-dire de machine électrotechnique considérée. Or, une erreur de branchement sur le dispositif de mesure peut s'avérer extrêmement dangereuse pour l'utilisateur.

Une solution possible consisterait à réaliser un dispositif de mesure fonctionnant uniquement selon une procédure préétablie guidant l'utilisateur au cours du branchement et de la mesure. Néanmoins, une telle éventualité limite les possibilités d'utilisation du dispositif de mesure et, surtout, n'a que peu d'intérêt du point de vue pédagogique.

L'invention vise donc à proposer un dispositif de mesure électrotechnique polyvalent permettant la mesure d'une pluralité de caractéristiques - notamment électriques et/ou électro-mécaniques et/ou mécaniques - d'une machine électrotechnique d'un type quelconque. Plus précisément, l'invention vise à proposer un tel dispositif de mesure qui peut être manipulé et utilisé sans danger pour l'utilisateur, même en cas de branchement totalement erroné ou d'erreur de manipulation. Simultanément, l'invention vise à proposer un tel dispositif de mesure à usage pédagogique qui n'impose pas de lui-même une procédure de branchement et de manipulation particulière.

L'invention vise également à proposer un tel dispositif de mesure électrotechnique pouvant être associé à un dispositif de traitement d'information permettant d'exploiter les mesures, notamment pour la comparaison avec des modèles mathématiques, le tracé de courbes de mesure, la présentation des mesures, et plus généralement leur exploitation complète.

L'invention vise également à proposer un dispositif de mesure électrotechnique pouvant mesurer toute sorte de caractéristiques d'une machine électrotechnique sans modification ou avec un nombre limité d'adaptation selon le type de machine électrotechnique considéré.

L'invention vise également à proposer un tel dispositif de mesure électrotechnique polyvalent réalisé de façon simple et à moindre coût et apte à mesurer dans des gammes de tensions de 0 à 500 V, d'intensité de 0 à 20 A et de puissance de 0 à 4 kW environ.

Pour ce faire, l'invention propose un dispositif de mesure électrotechnique polyvalent pour la mesure des caractéristiques d'une machine électrotechnique - notamment une machine à courant continu ; une machine asynchrone, synchrone, monophasée ou polyphasée ; un transformateur monophasé ou polyphasé ; un variateur de vitesse ... comprenant des moyens de connexion électrique en parallèle et/ou en série du dispositif à un circuit électrique associé à la machine électrotechnique, caractérisé en ce que les moyens de connexion électrique comprennent au moins une paire de bornes de connexion en série pour la détection d'une intensité reliées l'une à l'autre par un conducteur primaire couplé à un capteur d'intensité par effet Hall délivrant un signal représentatif de l'intensité, et au moins une paire de bornes de connexion en parallèle pour la détection d'une tension reliées l'une à l'autre par un conducteur primaire comprenant une résistance en série, et couplé avec un capteur d'intensité par effet Hall délivrant un signal représentatif de la tension.

Selon l'invention, chaque capteur d'intensité par effet Hall utilisé dans les moyens de connexion électrique est un capteur à champ magnétique compensé fournissant un signal analogique de mesure en intensité qui en phase avec l'intensité réelle du courant traversant le conducteur primaire reliant la paire de bornes de connexion considérée.

Selon l'invention, les moyens de connexion électrique sont constitués intégralement de paires de bornes de connexion reliées l'une à l'autre par un conducteur primaire couplé à un capteur d'intensité par effet Hall qui délivre un signal de mesure dont l'intensité instantanée est une fonction de l'intensité traversant le conducteur primaire.

Ainsi selon l'invention, les moyens de connexion électrique au circuit électrique associé à la machine électrotechnique sont parfaitement isolés galvaniquement du reste du dispositif de mesure, c'est-à-dire des circuits de traitement des signaux alimentés par les différents capteurs à effet Hall utilisés. Dès lors, les erreurs de branchement ou de manipulation sont sans conséquence sur le dispositif de mesure lui-même, ni sur la sécurité de l'utilisateur. Et les signaux de mesure élaborés peuvent être mis en forme de façon fiable et transformés pour pouvoir être délivrés à un dispositif de traitement informatique tel qu'un micro-ordinateur ou autre.

Le dispositif selon l'invention comporte trois paires de connexions en parallèle pour la détection de tensions sous trois phases et trois paires de bornes de connexion en série pour la détection de l'intensité sur trois phases. Avec ainsi six paires de bornes de connexion électrique, on peut en pratique aisément réaliser l'intégralité des mesures des caractéristiques électriques de toutes natures d'une machine électrotechnique d'un type quelconque.

Plus précisément, le dispositif selon l'invention comporte au moins un module wattmètrique comprenant une paire de bornes de connexion parallèles d'une phase pour les détections d'une tension, une paire de bornes de connexion en série d'une phase pour la détection d'une intensité, un circuit de puissance formant un signal analogique de puissance et comportant un multiplicateur analogique réalisant le produit des valeurs des signaux analogiques instantanés correspondant à la tension et à l'intensité. Le dispositif selon l'invention comporte avantageusement trois modules wattmètriques.

Selon une autre caractéristique de l'invention, le dispositif de mesure comporte une pluralité de circuits de mesure, chaque circuit de mesure comprenant des moyens de connexion à un circuit électrique ou à un transducteur de détection d'une caractéristique non nécessairement électrique. Chaque circuit de mesure délivre au moins un signal de mesure correspondant à la caractéristique concernée et le dispositif comporte des moyens de multiplexage des différents signaux analogiques de mesure générés par les différents circuits de mesure respectivement. Les moyens de multiplexage comportent, selon l'invention, au moins un multiplexeur analogique réalisant le multiplexage des signaux analogiques de mesure. Ce multiplexage analogique peut être réalisé de façon très simple puisque les bornes de connexion électriques notamment sont parfaitement isolées des moyens de multiplexage.

Le dispositif selon l'invention comporte une pluralité de cartes de mesure, chaque carte de mesure comprenant un circuit de mesure. Il comporte également une carte de conversion comprenant les moyens de multiplexage et des moyens de mise en forme des signaux de mesure en provenance de chaque carte de mesure, ces moyens de mise en forme délivrant les signaux à un dispositif de traitement informatique et/ou à un dispositif d'affichage et/ou à un dispositif de tracé. Les moyens de mise en forme des signaux comprennent un convertisseur analogique/numérique en sortie des moyens de multiplexage.

Le dispositif selon l'invention comporte des moyens de transformation en valeur efficace de signaux analogiques instantanés de mesure, et ces moyens de transformation en valeur efficace sont disposés à la sortie d'au moins un multiplexeur analogique des moyens de multiplexage dont l'entrée reçoit les différents signaux devant être transformés - notamment les tensions et les intensités électriques -. Le dispositif comporte néanmoins des moyens pour annuler ou shunter les moyens de transformation en valeur efficace afin de pouvoir délivrer des signaux correspondants à des valeurs instantanées.

Le dispositif selon l'invention comporte trois cartes de mesure électrique comportant chacune un module wattmètrique fournissant un signal analogique instantané de tension et d'intensité et un signal de puissance moyenne ou moyens de multiplexage de la carte de conversion. Il comporte également une carte de mesure de vitesse de rotation et/ou de glissement d'une machine électrotechnique tournante ; une carte de mesure de couple d'une machine électrotechnique tournante ; une carte de mesure de température ...

L'invention concerne également un dispositif de mesure électrotechnique polyvalent comprenant en combinaison tout ou partie des caractéristiques mentionnées ci-dessus ou ci-après.

D'autres caractéristiques ou avantages de l'invention apparaîtront à la lecture de la description suivante d'un de ses modes de réalisation préférentiels donné uniquement à titre non limitatif et qui se réfère aux figures annexées dans lesquelles :
- La figure 1 est une vue synoptique de circuits constitutifs d'un dispositif de mesure selon l'invention.
- La figure 2 est une vue en perspective d'un dispositif de mesure selon l'invention.
- Les figures 3a, 3b, 3c, 3d, 3e sont des schémas illustrant les circuits d'un module wattmètrique d'un dispositif de mesure selon l'invention, à savoir respectivement le circuit de mesure de l'intensité, le circuit de mesure de la tension, le circuit de mise en forme du signal d'intensité, le circuit de mise en forme du signal de tension, et le circuit de puissance.

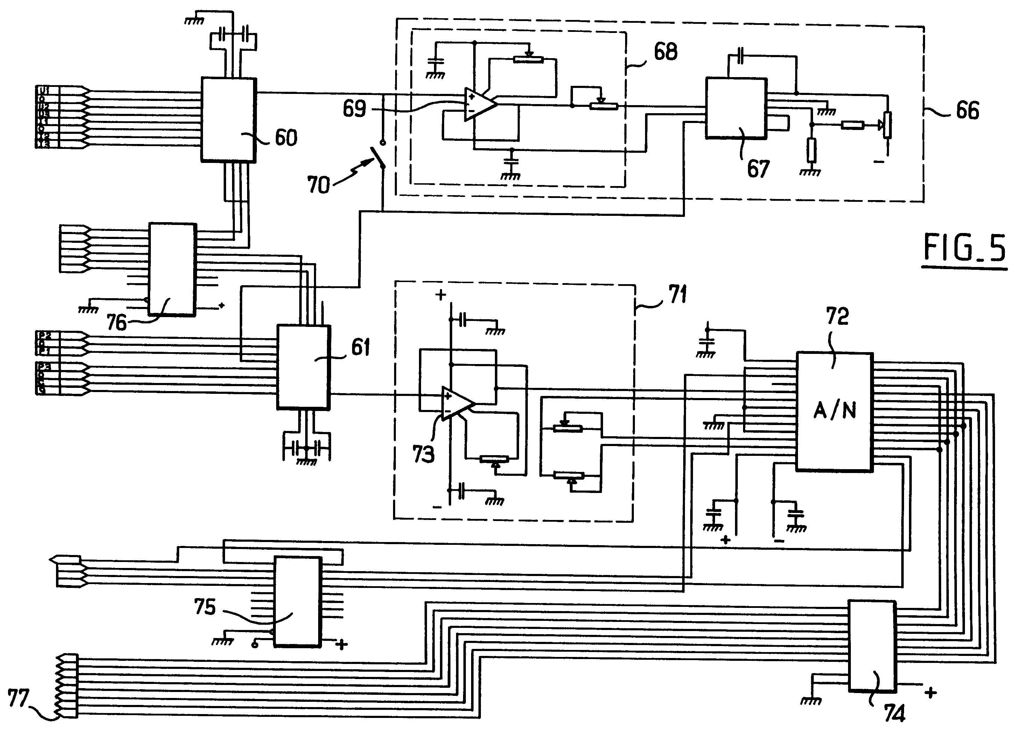

- La figure 5 est un schéma illustrant les circuits de la carte de conversion d'un dispositif de mesure selon l'invention.
- La figure 6 est un schéma illustrant le circuit d'une carte de mesure du couple d'un dispositif de mesure selon l'invention.
- La figure 7 est une vue synoptique de circuits constitutifs d'une carte de mesure de vitesse et de glissement d'un dispositif de mesure selon l'invention.
- La figure 8 est un schéma de montage illustrant un exemple d'utilisation d'un dispositif selon l'invention avec une machine tournante électrotechnique synchrone.

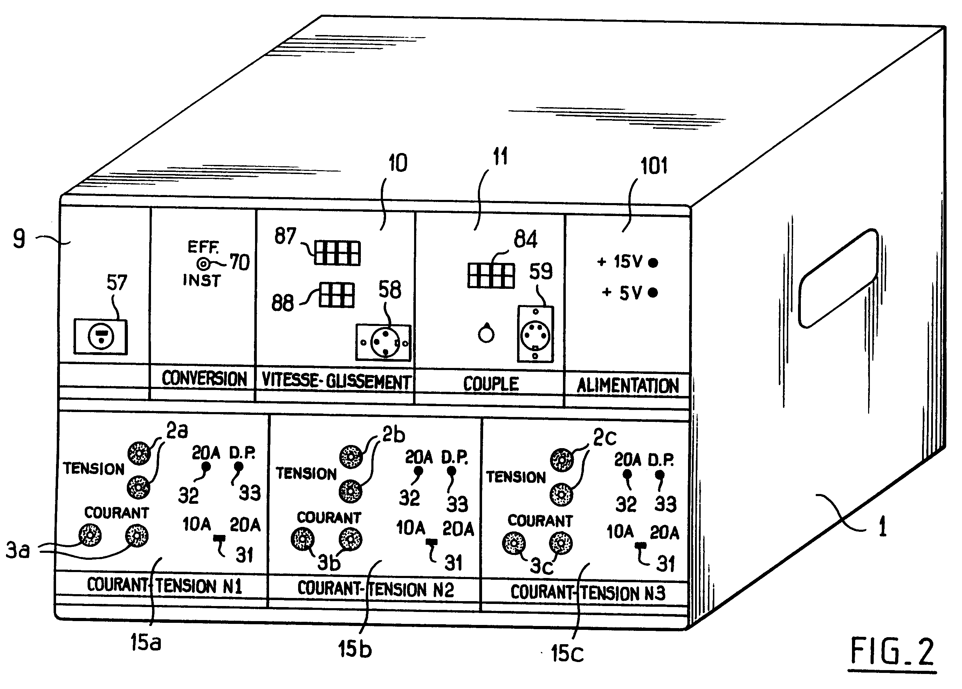

Sur la figure 2, on a représenté un exemple de réalisation d'un dispositif 1 de mesure électrotechnique polyvalent selon l'invention comprenant des moyens 2 de connexion électrique en parallèle et des moyens 3 de connexion électrique en série du dispositif 1 à un circuit électrique (non représenté à la figure 2) associé à la machine électrotechnique (non représentée à la figure 2) dont on veut mesurer des caractéristiques grâce au dispositif 1 selon l'invention.

Dans l'exemple de réalisation de la figure 2, les moyens 2, 3 de connexion électrique comprennent trois paires de bornes 3a, 3b, 3c de connexion en série pour la détection d'une intensité, et trois paires de bornes 2a, 2b, 2c de connexion en parallèle pour la détection d'une tension. Lorsque le dispositif 1 est destiné uniquement à des mesures en courant continu ou alternatif monophasé, on pourrait se contenter d'une seule paire de bornes de connexion en série et d'une seule paire de bornes de connexion en parallèle.

Selon l'invention, les bornes d'une paire de borne 3, de connexion en série pour la détection d'une intensité sont reliées l'une à l'autre par un conducteur primaire 5 couplé à un capteur d'intensité par effet Hall 7 délivrant un signal représentatif de l'intensité. Et les bornes d'une paire de bornes 2 de connexion en parallèle pour la détection d'une tension sont reliées l'une à l'autre par un conducteur primaire 4 comprenant une résistance 8 en série entre ces bornes 2, le conducteur primaire 4 étant couplé avec un capteur d'intensité par effet Hall 6 délivrant un signal représentatif de la tension.

Dans le dispositif 1 de mesure selon l'invention, les moyens 2, 3 de connexion électrique sont constitués intégralement des paires de bornes 2a, 2b, 2c, 3a, 3b, 3c de connexion reliées l'une à l'autre par un conducteur primaire 4, 5, couplé à un capteur d'intensité par effet Hall 6, 7 qui délivre un signal de mesure dont l'intensité instantanée est une fonction de l'intensité traversant le conducteur primaire 4, 5. Le dispositif 1 de mesure selon l'invention peut comporter d'autres cartes de mesure de caractéristiques non purement électriques. Sur la figure 2, on a représenté en partie haute des moyens de connexion du dispositif 1 selon l'invention à des transducteurs de mesure de caractéristiques non électriques : une carte 9 de mesure de température, une carte 10 de mesure de la vitesse et/ou du glissement, une carte 11 de mesure du couple. D'autres cartes de mesure peuvent être prévues.

La figure 2 représente la face avant du dispositif 1 de mesure comportant les moyens de connexion au circuit électrique ou à la machine électrotechnique et les différents moyens de commande et d'affichage du dispositif. La face arrière du dispositif 1 comprend des moyens de connexion de ce dispositif 1 à un dispositif 12 de traitement informatique tels qu'un micro-ordinateur comportant un écran 13 d'affichage et des moyens d'impression 14 tels qu'une table traçante ou une imprimante.

Selon l'invention, chaque capteur d'intensité par effet Hall 6, 7 est un capteur à champ magnétique compensé fournissant un signal analogique de mesure en intensité qui en phase avec l'intensité réelle du courant traversant le conducteur primaire 4, 5. Un tel capteur d'intensité par effet Hall peut être constitué d'un dispositif tel que décrit à la demande de brevet français FR-A-2 608 282 et commercialisé par la société LEM (Suisse) Chaque conducteur primaire 4, 5 est alors intégré au capteur à effet Hall 6, 7 correspondant. Un tel capteur d'intensité par effet Hall à champ magnétique nul permet des mesures aussi bien en courant alternatif qu'en courant continu. Dans le cas du capteur à effet Hall 6 de connexion en parallèle en vue de la détection d'une tension, une résistance 8 de valeur importante est insérée en série du conducteur primaire 4 entre les deux bornes. La valeur de cette résistance est déterminée pour que le courant circulant dans le conducteur primaire 4 ait une valeur correspondant à la précision optimale du capteur pour la tension nominale à mesurer. Classiquement, la précision d'un tel capteur est optimale pour un courant dans le conducteur primaire 4 de l'ordre de 10 milliampères. On choisit donc par exemple une résistance 8 de l'ordre de 40 kiloohms pour une mesure de tension jusqu'à 400 volts.

Dans le dispositif 1 de mesure selon l'invention, les bornes 2, 3 de connexion électrique sont des bornes de connexion pour trois modules wattmètriques 15 (ou un seul module wattmètrique 15 dans le cas d'une utilisation uniquement en monophasé ou en continu). Chaque module wattmètrique 15 comporte une paire de bornes 2 de connexion en parallèle d'une phase pour la détection d'une tension, et une paire de bornes 3 de connexion en série d'une phase pour la détection d'une intensité. Chaque module wattmètrique 15 comporte également un circuit 16 de puissance fournissant un signal analogique de puissance et comportant un multiplicateur analogique 17 réalisant le produit des valeurs des signaux analogiques instantanés correspondant à la tension et à l'intensité issus des capteurs à effet Hall 6, 7, associés aux bornes 2, 3 de connexion. Les trois modules wattmètriques 15a, 15b, 15c sont tous identiques et comportent chacun une paire de bornes de connexion 2a, 2b, 2c en parallèle et une paire de bornes de connexion 3a, 3b, 3c en série. On peut ainsi connecter trois phases au dispositif de mesure 1 selon l'invention.

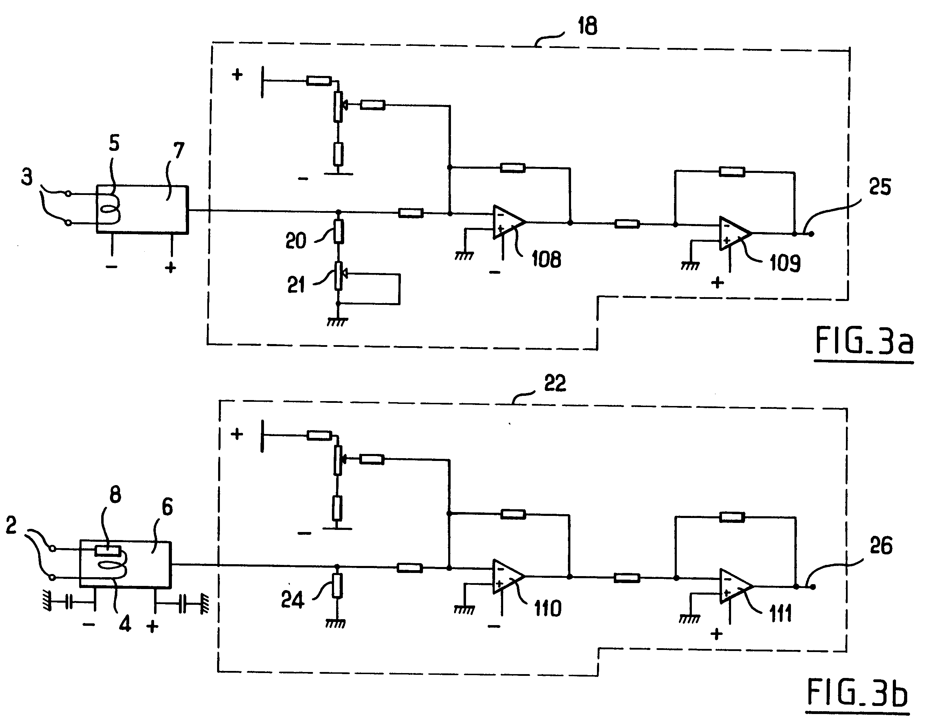

Les figures 3a à 3e illustrent des schémas électriques d'un mode de réalisation d'un module wattmètrique 15.

Sur la figure 3a, on a représenté le circuit de mesure d'intensité. Celui-ci se compose du capteur à effet Hall 7 suivi d'un montage suiveur 18 permettant d'adapter l'impédance d'entrée puis d'un circuit amplificateur 19. Le montage suiveur est réalisé avec au moins un - notamment deux - amplificateur opérationnel différentiel linéaire à faible dérive. Le premier amplificateur 108 permet le règlage de la valeur initiale d'offset et le second 109 permet d'abaisser l'impédance de sortie. Le circuit suiveur 18 comporte une résistance de mesure 20 et un potentiomètre 21 permettant de calibrer l'intensité.

La figure 3b illustre un schéma du circuit de mesure de la tension. Ce circuit comprend le capteur 6 à effet Hall relié aux bornes 2 de connexion en parallèle, et comprenant son conducteur primaire 4 avec sa résistance 8. Le capteur 6 est également suivi d'un montage suiveur 22 réalisé de façon analogue au montage suiveur 18 du circuit de mesure d'intensité précédemment décrit. Le montage suiveur 22 comporte également une résistance 24 de mesure permettant d'adapter la valeur du signal en fonction de la valeur nominale à mesurer. Là encore, le montage suiveur 22 est réalisé à partir d'amplificateurs opérationnels 110, 111 différentiels linéaires à faible dérive, avec leurs résistances associées. Le premier amplificateur opérationnel 110 permet la correction de la valeur initiale d'effet et le second 111 permet d'adapter l'impédance en sortie.

La sortie 25 et respectivement 26 des montages suiveurs 18 du circuit de mesure de l'intensité, respectivement 22 du circuit de mesure de la tension délivre des signaux analogiques instantanés en tension donnant des images de l'intensité, respectivement de la tension mesurée aux bornes 3, respectivement 2 de connexion électrique. Ces signaux en tension sont délivrés à l'entrée 27 respectivement 28 d'un circuit 29 de mise en forme du signal d'intensité, respectivement 23 de mise en forme du signal de tension.

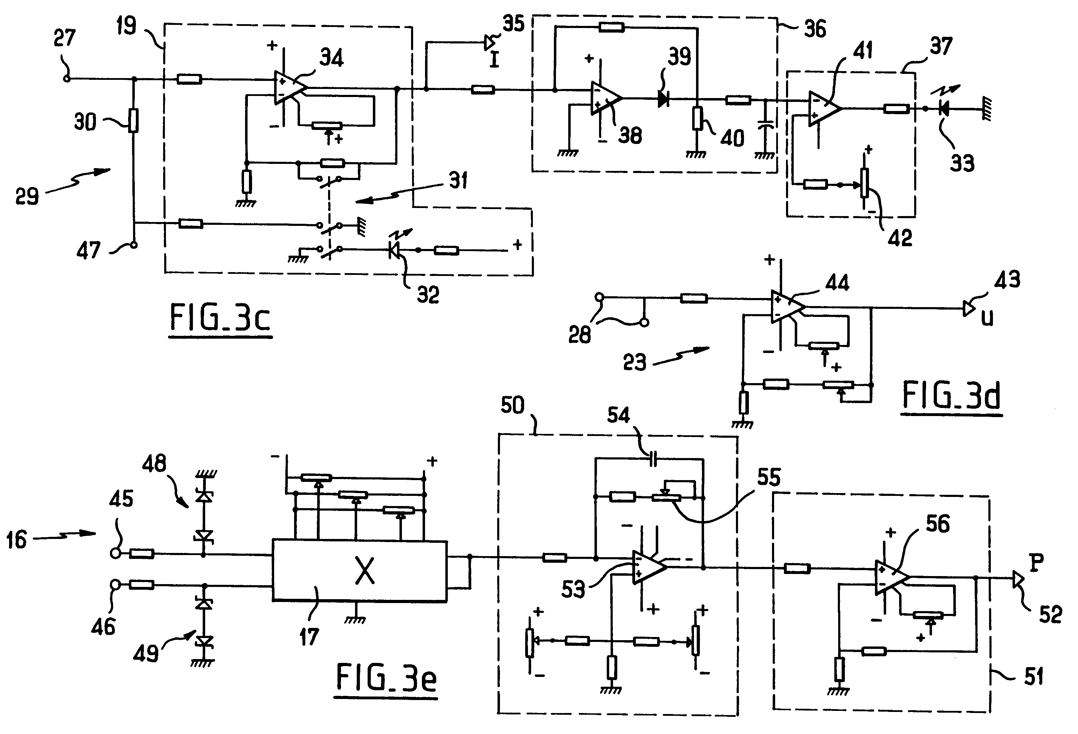

Chaque module wattmètrique 15 comporte par ailleurs un interrupteur 31 permettant de modifier le calibre d'intensité, par exemple de le passer de 10 à 20 ampères, ainsi qu'une diode lumineuse 32 permettant d'indiquer la position de l'interrupteur 31. Egalement, une diode lumineuse 33 permet d'indiquer un dépassement du calibre d'intensité. La figure 3c illustre un schéma de réalisation du circuit 29 de mise en forme du signal d'intensité. L'interrupteur 31 permet de modifier le gain d'un amplificateur opérationnel 34 d'un montage amplificateur 19 placé après le montage suiveur 18. Lorsque l'interrupteur 31 est ouvert, le gain est par exemple de 2, le calibre est de 10 ampères, et la diode lumineuse 32 est éteinte. Lorsque l'interrupteur 31 est fermé, le gain de l'amplificateur opérationnel 34 passe à 1, le calibre est de 20 ampères et la diode lumineuse 32 s'allume. De la sorte, la sortie analogique 35 du signal analogique instantané d'intensité est toujours calibrée à 10 volts.

Pour détecter le dépassement du calibre, on utilise un circuit redresseur double alternance 36 suivi d'un circuit comparateur 37. Le circuit redresseur double alternance 36 est constitué d'un amplificateur opérationnel 38 suivi d'une diode 39 avec une résistance 40 formant diviseur de tension pour réaliser l'égalité des amplitudes redressées. Le circuit redresseur double alternance 36 permet de pouvoir détecter un dépassement de calibre de façon simple quelque soit la nature de la grandeur mesurée, c'est-à-dire alternative, continue positive ou continue négative.

La sortie du circuit comparateur 37 allume la diode 33 de dépassement de calibre lorsque le signal d'intensité dépasse la calibre affiché. Le circuit comparateur 37 est également essentiellement constitué d'un amplificateur opérationnel 41 et d'un potentiomètre 42 d'étalonnage.

La figure 3d illustre le montage amplificateur 23 disposé en sortie du montage suiveur 22, qui permet également de fournir un signal en tension en sortie 43 calibré à 10 volts. Ce montage amplificateur 23 est essentiellement constitué d'un amplificateur opérationnel 44 avec ses résistances associées, et constitue le circuit de mise en forme du signal analogique de tension délivré à la sortie analogique 43.

La figure 3e illustre le circuit de puissance 16.

Ce circuit de puissance est alimenté par les signaux d'intensité et de tension pris en amont des circuits amplificateurs 29, 30. Plus précisément, l'entrée 45 de tension correspond à la borne 28 d'entrée du montage amplificateur 23 du signal de tension, alors que l'entrée 46 du signal d'intensité correspond à la borne 47 du circuit 29 (figure 3c) qui est reliée à l'entrée 27 du montage amplificateur 19 par l'intermédiaire d'une résistance 30. Les entrées 45, 46 sont suivies chacune de deux diodes Zener 48, 49 montées tête bêche pour protéger le multiplicateur analogique 17 contre les surtensions. La sortie du multiplicateur analogique 17 correspond à une tension proportionnelle à la puissance instantanée, c'est-à-dire au produit de la tension instantanée par l'intensité instantanée. Le multiplicateur analogique 17 est suivi d'un filtre passe-bas 50 permettant de déterminer la puissance moyenne en supprimant la composante fluctuante de la puissance instantanée. Ce filtre passe-bas 50 est lui-même suivi d'un circuit amplificateur 51 permettant d'avoir sur la sortie 52 un signal en tension de plus ou moins 10 volts fournissant une image de la puissance. Le filtre passe-bas 50 est constitué d'un amplificateur opérationnel 53 et d'un condensateur 54 avec des résistances associées permettant de laisser passer la composante continue du signal d'entrée. Le potentiomètre 55 permet d'étalonner le filtre passe-bas.

Le circuit amplificateur 51 est constitué essentiellement d'un amplificateur opérationnel 56.

Comme on le voit, chaque module wattmètrique ainsi constitué fournit en 35 un signal d'intensité I, en 43 un signal de tension U, et en 52 un signal de puissance moyenne P.

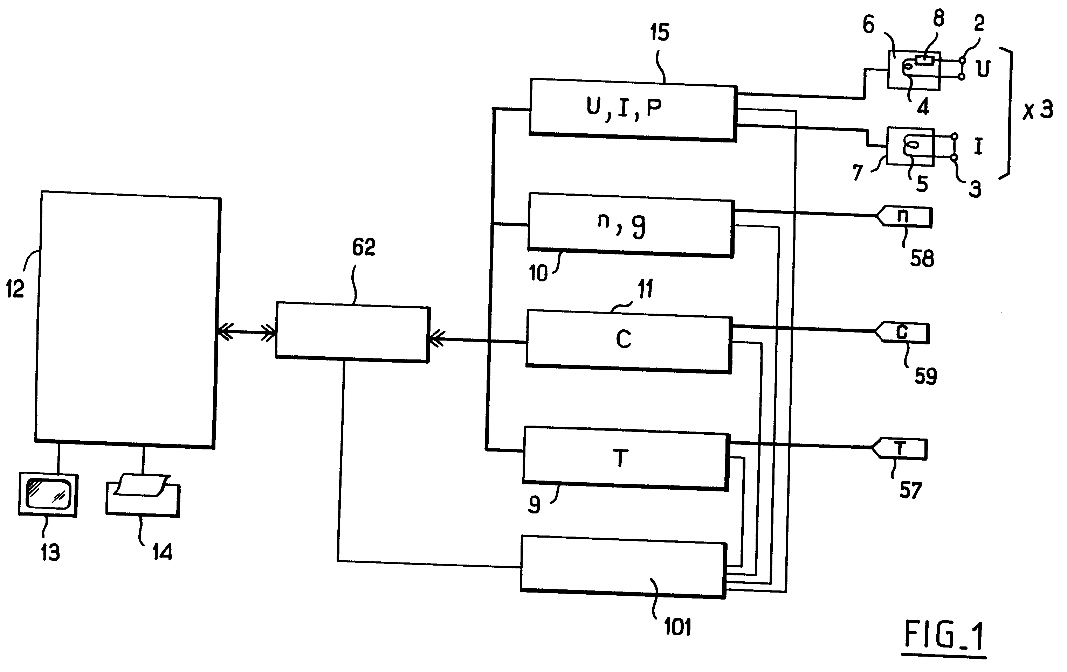

La figure 1 illustre la constitution générale du dispositif 1 de mesure qui comprend une pluralité de circuits de mesure 9, 10, 11, 15, chaque circuit de mesure comprenant des moyens 57, 58, 59, 2, 3 de connexion à un circuit électrique ou à la sortie d'un transducteur de détection d'une caractéristique non purement électrique. On prévoit par exemple une borne de connexion 57 pour une sonde thermique, une borne de connexion 58 pour un détecteur de vitesse de rotation fournissant des impulsions proportionnelles à la vitesse de rotation, et une borne de connexion 59 pour la sortie d'un transducteur de mesure du couple qui peut être par exemple constitué d'un pont de jauges de contrainte. Chaque circuit de mesure 9, 10, 11, 15 délivre au moins un signal de mesure analogique. Et le dispositif selon l'invention comporte des moyens 60, 61 de multiplexage des différents signaux analogiques de mesure délivrés par chaque circuit de mesure. Les moyens 60, 61 de multiplexage comportent au moins un multiplexeur analogique réalisant le multiplexage des signaux analogiques de mesure. L'utilisation d'un multiplicateur analogique 17 et de multiplexeurs analogiques 60, 61 est en particulier permise grâce à l'isolation galvanique parfaite obtenue grâce aux capteurs à effet Hall 6, 7.

Chaque circuit 9, 10, 11, 15 de mesure est supporté par une carte de mesure, le dispositif 1 selon l'invention comportant une pluralité de cartes de mesure 9, 10, 11, 15, comprenant chacune ledit circuit de mesure. Le dispositif 1 selon l'invention comporte également une carte de conversion 62 comprenant les moyens 60, 61 de multiplexage et des moyens 64, 65, 66 de mise en forme des signaux pour un dispositif de traitement informatique 12 et/ou dispositif d'affichage 13 et/ou un dispositif de tracé 14. Dans le mode de réalisation représenté sur la figure 1, la carte de conversion 62 fournit les signaux au dispositif de traitement informatique 12 qui gère l'écran d'affichage 13 et le dispositif de tracé 14. Les moyens 64, 65, 66 de mise en forme des signaux comportent un convertisseur analogique/numérique en sortie des moyens 60, 61 de multiplexage.

Dans le mode de réalisation représenté sur les figures, le dispositif 1 comporte trois cartes de mesure électrique 15a, 15b, 15c comportant chacune un module wattmètrique fournissant un signal analogique instantané de tension U1, U2, U3 et d'intensité I1, I2, I3, et un signal de puissance moyenne P1, P2, P3 aux moyens 60, 61 de multiplexage de la carte de conversion 62.

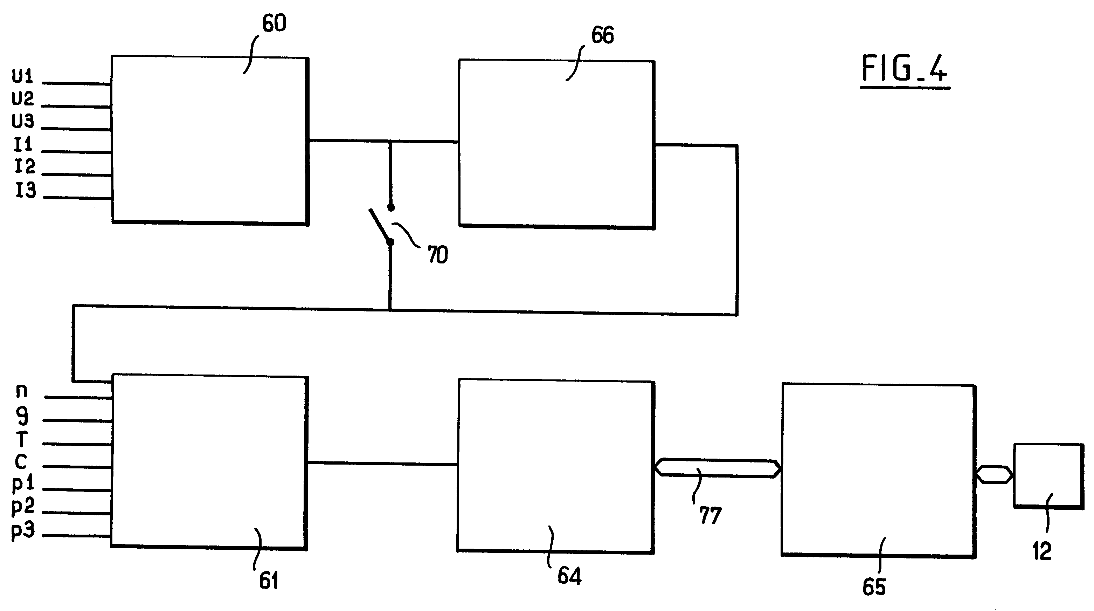

Comme représenté sur la figure 4, la carte de conversion 62 comporte des moyens 66 de transformation en valeur efficace des signaux analogiques instantanés de mesure - notamment des signaux instantanés de tension et d'intensité U1, U2, U3, I1, 12, I3. Ces moyens 66 de transformation en valeur efficace sont disposés à la sortie d'au moins un multiplexeur analogique 60 des moyens 60, 61 de multiplexage dont l'entrée reçoit les différents signaux devant être transformés, c'est-à-dire les tensions et les intensités électriques en provenance des cartes de mesure wattmètrique 15.

Ces moyens 66 de transformation en valeur efficace sont constitués essentiellement d'un circuit intégré 67 RMS qui réalise la transformation de signaux instantanés en signaux continus équivalents. L'entrée de ce circuit intégré 67 est équipée d'un montage suiveur 68 constitué d'un amplificateur opérationnel 69. Ces composants actifs 67, 69 sont équipés des composants associés habituels permettant notamment le réglage de la valeur initiale d'offset et de la sensibilité.

Le dispositif de mesure selon l'invention comporte également des moyens 70 pour annuler ou shunter les moyens 66 de transformation en valeur efficace. Dans le mode de réalisation représenté sur les figures, ces moyens 70 sont constitués d'un commutateur 70 qui permet de shunter les moyens 66 de transformation en valeur efficace. Lorsque le commutateur 70 est fermé, la sortie du multiplexeur analogique 60 est directement connectée à une entrée du deuxième multiplexeur 61. Dans cette position, le dispositif de mesure selon l'invention fournit au micro-ordinateur 12 des signaux de tension et d'intensité instantanés et joue donc le rôle d'un oscilloscope numérique.

Les signaux de vitesse, de glissement, de couple, de température, de puissance ou autres sont généralement des signaux de valeur moyenne ou de valeur continue. On prévoit donc un premier multiplexeur 60 recevant les signaux de valeur instantanée de tension et d'intensité U1, U2, U3, I1, I2, I3 et un deuxième multiplexeur 61 recevant les signaux émis en valeur moyenne ou continue. Les deux multiplexeurs 60, 61 sont montés en cascade, c'est-à-dire que la sortie du premier multiplexeur 60 est reliée à une entrée du second multiplexeur 61, par l'intermédiaire des moyens de transformation en valeur efficace 66 comme déjà dit. On peut également utiliser une voie du second multiplexeur 61 pour transmettre un signal instantané de mesure au micro-ordinateur 12. En effet, ce second multiplexeur 61 est disposé en aval des moyens 66 de transformation en valeur efficace. Les signaux reçus par le second multiplexeur 61 sont les signaux de puissance moyenne P1, P2, P3 de vitesse n, de glissement g, de température t, de couple c, ou autres.

A la sortie des moyens 60, 61 de multiplexage, c'est-à-dire à la sortie du deuxième multiplexeur 61, on prévoit un montage suiveur 71 qui permet également un réglage de valeur initiale d'offset de façon que le signal soit mis à niveau à l'entrée d'un circuit intégré 72 de conversion analogique/numérique. Ce circuit intégré 72 avec le montage suiveur 71 constituent des moyens 64 de conversion analogique/numérique du signal en sortie des moyens 60, 61 de multiplexage. Ainsi, le circuit intégré 72 convertit sur 12 bits numériques le signal analogique en entrée qui est fourni par le multiplexeur 61.

Le montage suiveur 71 est essentiellement constitué d'un amplificateur opérationnel 73 avec ses composants associés. Le signal numérique de sortie du circuit intégré 72 de convertisseur analogique/numérique est formé sur 8 bits à destination du micro-ordinateur 12. Une mémoire tampon 74 est prévue en sortie du convertisseur analogique/numérique 72. Egalement, des mémoire tampons 75, 76 sont associées au convertisseur 72 et aux multiplexeurs 60, 61 pour faciliter la synchronisation qui peut être réalisée à partir de signaux de commande et de cadencement émis par le micro-ordinateur 12 programmé à cet effet. Les signaux de commande et de cadencement permettent en particulier de synchroniser le convertisseur analogique/numérique sur 12 bits pour que le signal puisse être émis sur un bus de 8 bits successivement sur 8 bits et sur 4 bits.

Le signal numérique à la sortie 77 des moyens 64 de conversion analogique/numérique est fourni via un circuit d'interface 65 au micro-ordinateur 12. Le circuit d'interface 65 est adapté en fonction du micro-ordinateur 12 utilisé et est donc constitué simplement d'une carte entrée/sortie compatible avec ce micro-ordinateur 12.

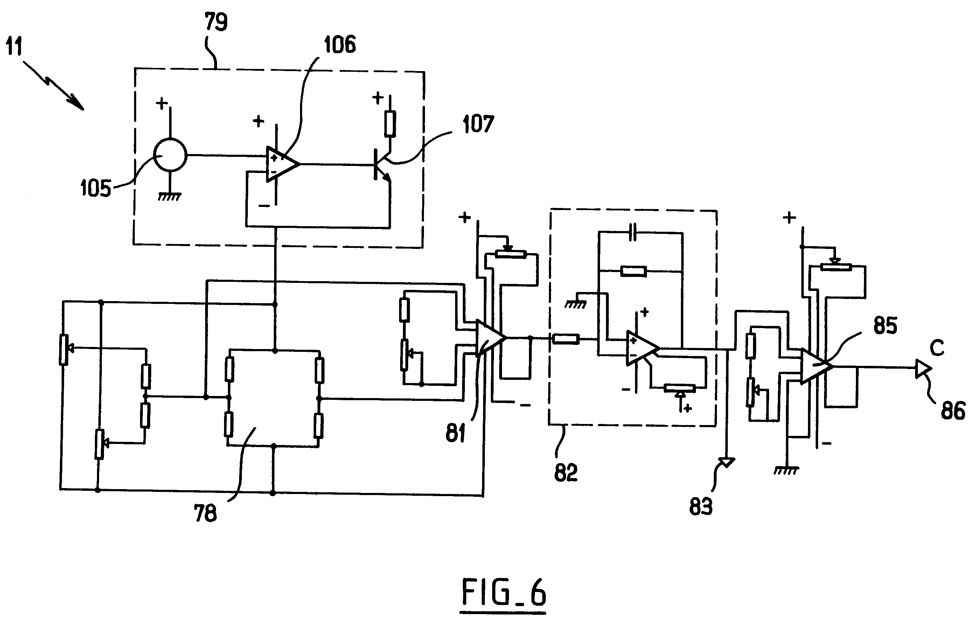

La figure 6 illustre un schéma électronique de réalisation d'une carte 11 de mesure de couple d'un dispositif 1 selon l'invention. Cette carte permet d'exploiter une variation de tension continue issue d'un pont de mesure à jauges de contrainte collées sur une éprouvette en acier elle-même montée sur la machine électrotechnique tournante telle qu'un moteur en vue d'en mesurer le couple.

Le pont de jauges 78 (qui n'est pas partie intégrante de la carte 11 de mesure elle-même bien qu'il soit représenté sur la figure 6) est alimenté en tension continue fixe grâce à une référence de tension 79 fournissant une tension continue non fluctuante avec la température. La référence de tension 79 est composée d'une alimentation stabilisée 105 d'un amplificateur opérationnel 106 et d'un transistor 107 qui permet la fourniture de courant avec une intensité importante. Le pont de jauges 78 émet un signal qui est immédiatement amplifié par un amplificateur opérationnel 81 à grande impédance d'entrée. A la sortie de cet amplificateur opérationnel 81, un filtre passe-bas 8é0 dont la fréquence de coupure est de 1 hertz supprime toutes les tensions parasites alternatives. A la sorite du filtre passe-bas 82, ce signal en tension est fourni en 83 à un voltmètre d'affichage 84 de la face avant du dispositif 1 de mesure selon l'invention. Enfin, un amplificateur opérationnel 85 à grande impédance d'entrée fournit sur une sortie analogique 86 un signal en tension de plus ou moins 10 volts. C'est ce signal analogique de sortie 86 qui est fourni au multiplexeur 61 de la carte de conversion 62.

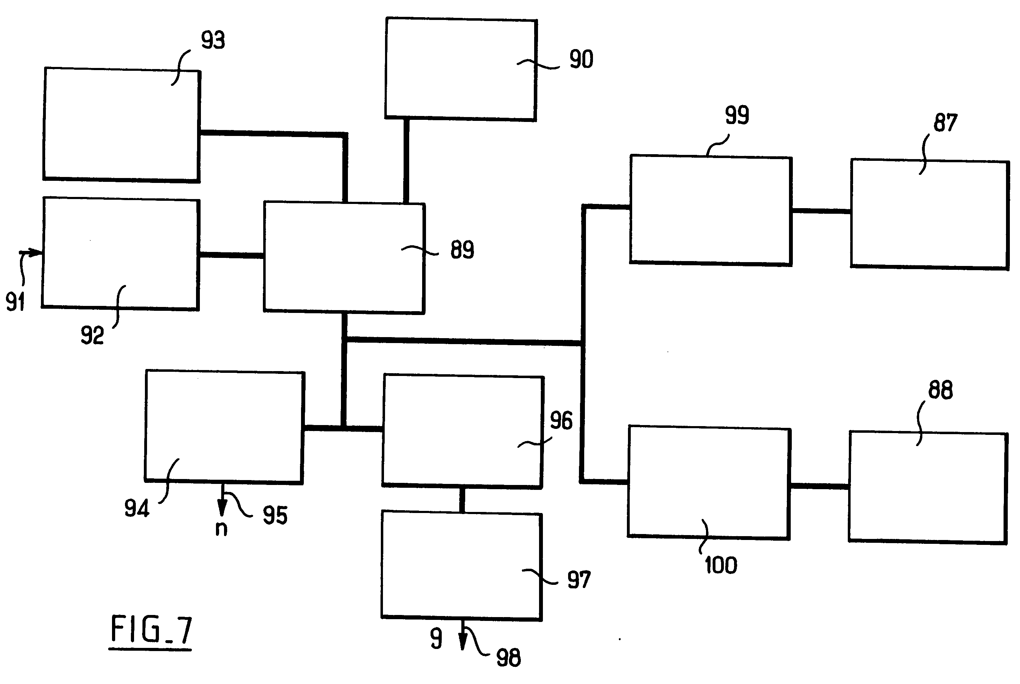

La figure 7 illustre le synoptique d'un mode de réalisation d'une carte de mesure de vitesse et de glissement d'un dispositif de mesure selon l'invention. Cette carte permet de mesurer la vitesse d'une machine tournante électrotechnique et d'afficher la vitesse et le glissement sur des moyens d'affichage 87, respectivement 88 de la face avant du dispositif 1 de mesure. Cette carte 10 de mesure de vitesse de rotation et de glissement comporte un microcontrôleur 89.

Des moyens 90 de saisie permettent de saisir et de transmettre au microcontrôleur 89 la vitesse de synchronisme de la machine tournante et le nombre d'impulsions par tour de rotation de la machine. Ces moyens 90 de saisie peuvent être constitués par exemple de cavaliers ou de commutateurs permettant de sélectionner par exemple la vitesse entre quatre vitesses de synchronisme telles que 750 , 1000, 1500 ou 3000 tours par minute.

La vitesse de la machine tournante peut être mesurée grâce à un disque percé sur sa périphérie de 1 ou de 60 trous et entraîné en rotation avec l'axe de la machine. Un dispositif optoélectronique envoie un signal en 91 sous forme d'impulsions dont la fréquence correspond à la vitesse de rotation. Ces impulsions sont mises en forme dans un circuit 92 qui transforme les impulsions analogiques en signaux carrés pour le microcontrôleur 89 qui compte les impulsions toutes les secondes.

Le circuit 93 est une base de temps fournie au microcontrôleur 89. Le signal numérique fourni par le microcontrôleur 89 est fourni à un convertisseur numérique analogique 94 qui fournit un signal analogique de la vitesse en 95. Le signal est également fourni à un convertisseur numérique/numérique 96 qui transforme le signal numérique de vitesse en un signal numérique de glissement. Ce convertisseur 96 peut être constitué d'une simple mémoire EPROM contenant les différentes valeurs possibles de vitesse de synchronisme. Le microcontrôleur 89 fournit à ce convertisseur 96 un code d'adresse correspondant à la vitesse de synchronisme saisie, de sorte que ce convertisseur 96 transforme le code numérique sous 12 bits d'entrée de la vitesse en un code binaire sur 8 bits du glissement. En effet, le glissement est exprimé en un pourcentage compris entre moins 9,9 % et plus 9,9 %. Le signal numérique du glissement est ensuite fourni à un convertisseur numérique/analogique 97 qui fournit en sortie 98 le signal destiné au multiplexeur 61 de la carte de conversion 62.

Par ailleurs, le signal numérique émis par le microcontrôleur 89 peut être directement fourni à des moyens 99, respectivement 100 de conversion du signal pour des moyens d'affichage 87 de la vitesse, respectivement 88 du glissement. On peut utiliser pour ce faire des mémoires EPROM dont les bus d'adresse sont montés en parallèle.

Le dispositif 1 de mesure selon l'invention comporte également une carte de mesure 9 de température ou d'une autre caractéristique réalisée de façon analogue. D'autres cartes de mesure peuvent être prévues de façon non limitative, et les possibilités du dispositif 1 selon l'invention sont quasiment sans limite à cet égard. A partir d'un certain nombre de cartes de mesure, il pourra être nécessaire éventuellement de multiplier les cartes de conversion 62 et de les disposer en cascade. Egalement, une carte d'alimentation 101 est prévue pour fournir les tensions plus 5 volts, plus 15 volts à l'utilisateur et les tensions continus 0 volt, plus et moins 5 volts, plus et moins 15 volts aux différents circuits des cartes.

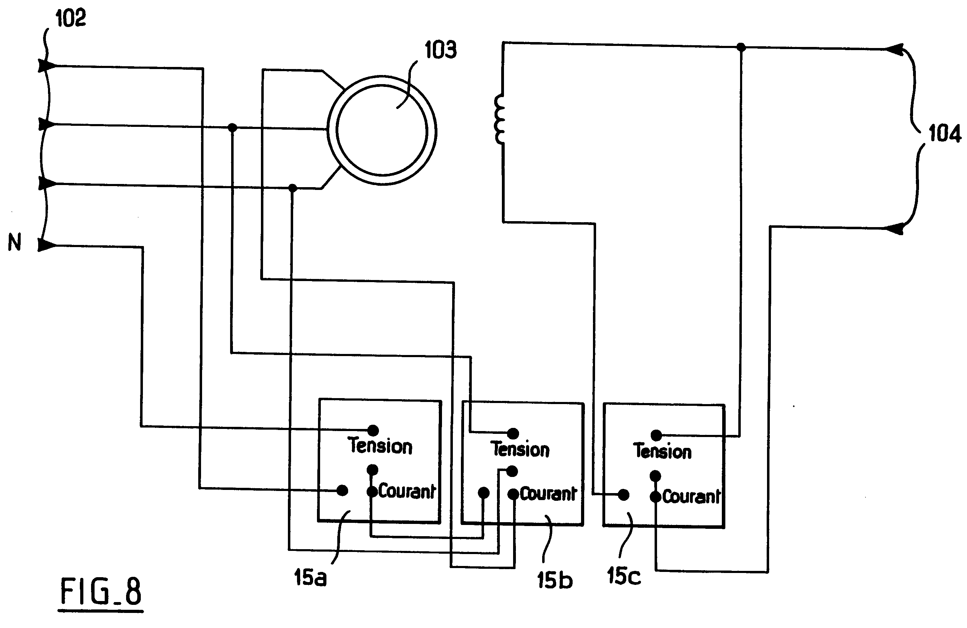

La figure 8 illustre un exemple d'utilisation d'un dispositif 1 selon l'invention dans le cas d'une machine synchrone triphasée. Le réseau triphasé 400 volts est fourni en 102 sur trois phases et un neutre N. Les modules wattmètriques 15a, 15b, 15c sont connectés comme indiqué sur la figure 8 entre le réseau 102 et la machine 103. Le réseau 220 volts continu 104 est relié au module wattmètrique 15c. Le module wattmètrique 15a mesure la puissance active P, le module wattmètrique 15b mesure la puissance de réaction Q et le le module wattmètrique 15c mesure la puissance d'excitation.

Grâce au micro-ordinateur 12 programmé à cet effet, on pourra réaliser, tracer les mesures réelles des caractéristiques de la machine 103 et les comparer au schéma équivalent théorique immédiatement. Bien évidemment, l'exemple de la figure 8 n'est pas limitatif et tout autre montage avec tout autre type de machine tournante ou non tournante électrotechnique pourra être réalisé.

L'homme du métier pourra réaliser les fonctions logiques et choisir les composants décrits ci-dessus et représentés sur les figures de façon connue en soi.

## Revendications

1. Dispositif de mesure électrotechnique polyvalent pour la mesure des caractéristiques d'une machine électrotechnique - notamment une machine à courant continu ; une machine asynchrone, synchrone, monophasée ou polyphasée ; un transformateur monophasé ou polyphasé ; un variateur de vitesse ... - comprenant des moyens (2, 3) de connexion électrique en parallèle et/ou en série du dispositif à un circuit électrique associé à la machine électrotechnique, caractérisé en ce qu'il comporte au moins un module wattmètrique (15) comprenant des moyens (2) de connexion en parallèle d'une phase pour la détection d'une tension, des moyens (3) de connexion en série d'une phase pour la détection d'une intensité, un circuit de puissance (16) formant un signal analogique de puissance et comportant un multiplicateur analogique (17) réalisant le produit des valeurs des signaux analogiques instantanés correspondant à la tension et à l'intensité, et en ce que les moyens (2, 3) de connexion électrique de chaque module wattmétrique (15) comprennent au moins une paire de bornes (3a, 3b, 3c) de connexion en série pour la détection d'une intensité reliées l'une à l'autre par un conducteur primaire (5) couplé à un capteur d'intensité par effet Hall (7) délivrant un signal représentatif de l'intensité, et au moins une paire de bornes (2a, 2b, 2c) de connexion en parallèle pour la détection d'une tension reliées l'une à l'autre par un conducteur primaire (4) comprenant une résistance (8) en série, et couplé avec un capteur d'intensité par effet Hall (6) délivrant un signal représentatif de la tension.

2. Dispositif selon la revendication 1 caractérisé en ce que chaque capteur d'intensité par effet Hall (6, 7) est un capteur à champ magnétique compensé fournissant un signal analogique de mesure en intensité qui est en phase avec l'intensité réelle du courant traversant le conducteur primaire (4, 5).

3. Dispositif selon l'une quelconque des revendications 1 et 2 caractérisé en ce que les moyens (2, 3) de connexion électrique sont constitués intégralement de paires de bornes (2a, 2b, 2c, 3a, 3b, 3c) de connexion reliées l'une à l'autre par un conducteur primaire (4, 5) couplé à un capteur d'intensité par effet Hall (6, 7) qui délivre un signal de mesure dont l'intensité instantanée est une fonction de l'intensité traversant le conducteur primaire (4, 5).

4. Dispositif selon l'une quelconque des revendications 1 à 3, caractérisé en ce qu'il comporte trois paires de bornes (2a, 2b, 2c) de connexion en parallèle pour la détection de tension sur trois phases et trois paires de bornes (3a, 3b, 3c) de connexion en série pour la détection de l'intensité sur trois phases.

5. Dispositif selon l'une des revendications 1 à 4 caractérisé en ce qu'il comporte trois modules wattmètriques (15a, 15b, 15c).

6. Dispositif selon l'une quelconque ces revendications 1 à 5 caractérisé en ce qu'il comporte une pluralité de circuits de mesure (9, 10, 11, 15), chaque circuit de mesure comprenant des moyens (57, 58, 59, 2, 3) de connexion à un circuit électrique ou à un transducteur de détection d'une caractéristique, et délivrant au moins un signal de mesure et en ce qu'il comporte des moyens (60, 61) de multiplexage des différents signaux de mesure.

7. Dispositif selon la revendication 6, caractérisé en ce que les moyens (60, 61) de multiplexage comportent au moins un multiplexeur analogique réalisant le multiplexage des signaux analogiques de mesure.

8. Dispositif selon l'une quelconque des revendications 1 à 7 caractérisé en ce qu'il comporte une pluralité de cartes de mesure (9, 10, 11, 15) comprenant chacune un circuit de mesure, et une carte de conversion (62) comprenant des moyens (60, 61) de multiplexage et des moyens (64, 65, 66) de mise en forme des signaux pour un dispositif de traitement informatique (12) et/ou un dispositif d'affichage (13) et/ou un dispositif de tracé (14).

9. Dispositif selon la revendication 8 caractérisé en ce qu'il comporte trois cartes de mesures électriques (15a, 15b, 15c) comportant chacune un module wattmètrique (15) fournissant un signal analogique instantané de tension et d'intensité et un signal de puissance moyenne aux moyens (60, 61) de multiplexage de la carte de conversion (62).

10. Dispositif selon l'une des revendications 8 et 9 caractérisé en ce que les moyens (64, 65, 66) de mise en forme des signaux comprennent un convertisseur analogique/numérique en sortie des moyens (60, 61) de multiplexage.

11. Dispositif selon l'une des revendications 6 à 10, caractérisé en ce qu'il comporte des moyens (66) de transformation en valeur efficace de signaux analogiques instantanés de mesure, et en ce que ces moyens (66) de transformation en valeur efficace sont disposés à la sortie d'au moins un multiplexeur analogique (60) des moyens (60, 61) de multiplexage, dont l'entrée reçoit les différents signaux de mesure devant être transformés - notamment les tensions et les intensités électriques.

12. Dispositif selon l'une des revendications 6 à 11, caractérisé en ce que les moyens (60, 61) de multiplexage comprennent un premier multiplexeur (60) recevant les signaux de valeur instantannée de tension et d'intensité (U1, U2, U3, I1, I2 I3) et un deuxième multiplexeur (61) recevant les signaux émis en valeur moyenne ou continue

13. Dispositif selon les revendications 11 et 12, caractérisé en ce que les moyens (66) de transformation en valeur efficace sont disposés à la sortie du premier multiplexeur (60) et en ce que le deuxième multiplexeur (61) est disposé en aval des moyens (66) de transformation en valeur efficace.

14. Dispositif selon l'une des revendications 12 et 13 caractérisé en ce que les deux multiplexeurs (60, 61) sont montés en cascade.

15. Dispositif selon l'une des revendications 1 à 14, caractérisé en ce que le multiplicateur analogique (17) de chaque circuit de puissance (16) est suivi d'un circuit comportant un filtre passe-bas (50) fournissant la puissance moyenne en supprimant la composante fluctuante de la puissance instantanée.

16. Dispositif selon l'une des revendications 11 à 15, caractérisé en ce qu'il comporte des moyens (70) pour annuler ou shunter les moyens (66) de transformation en valeur efficace.

17. Dispositif selon l'une quelconque des revendications 1 à 16, caractérisé en ce qu'il comporte une carte de mesure (10) de vitesse de rotation et/ou de glissement d'une machine électrotechnique tournante.

18. Dispositif selon l'une quelconque des revendications 1 à 17 caractérisé en ce qu'il comporte une carte de mesure (11) du couple d'une machine électrotechnique tournante.

19. Dispositif selon l'une quelconque des revendications 1 à 18, caractérisé en ce qu'il comporte une carte de mesure (9) de température.
